# EUROPÄISCHE PATENTSCHRIFT

(11) **EP 2 711 971 B1**
(45) Veröffentlichungstag und Bekanntmachung des Hinweises auf die Patenterteilung: **16.11.2016**
(21) Anmeldenummer: 12185564.7
(22) Anmeldetag: 21.09.2012
(51) Int. Cl.: H01L 21/027, H05K 3/04

(54) **Verfahren zur Herstellung einer strukturierten Dünnschicht**
Method for producing a structured thin film
Procédé de fabrication d'une couche mince structurée

(43) Veröffentlichungstag der Anmeldung: 26.03.2014
(73) Patentinhaber: JUMO GmbH & Co. KG, 36039 Fulda (DE)
(72) Erfinder: Wolf, Andreas, 63840 Hausen (DE)
(74) Vertreter: Schwabe - Sandmair - Marx

(56) Entgegenhaltungen:
- EP-A2- 2 151 870
- WO-A2-2008/074879
- JP-A- 2005 045 156
- US-A1- 2004 048 171

## Beschreibung

Die Erfindung betrifft ein Verfahren zur Herstellung einer strukturierten Dünnschicht.

Unter Dünnschichten werden für gewöhnlich funktionelle oder dekorative Schichten fester Stoffe auf einem Substrat mit einer Dicke im Nanometer- bis Mikrometerbereich verstanden. Bei einer strukturierten Dünnschicht sind nur bestimmte Bereiche der Substratoberfläche beschichtet. Die Auftragung von Dünnschichten erfolgt üblicherweise durch chemische oder physikalische Gasphasenabscheidung. Des Weiteren ist eine Auftragung von Dünnschichten durch galvanische Prozesse möglich.

Sowohl additive als substraktive Verfahren zur Erzeugung solcher Schichten sind bekannt. Bei den erstgenannten wird die Oberfläche des Substrats mit einer Maske abgedeckt oder lokal so vorbehandelt, dass die Dünnschicht nur auf den vorgegebenen Bereichen der Oberfläche aufgebracht wird. Bei den zuletzt genannten Verfahren wird zuerst die gesamte Oberfläche beschichtet und danach lokal ein Teil der Dünnschicht wieder abgetragen.

Zu den additiven Verfahren gehört zum Beispiel die Schablonentechnik, bei der planare Schablonen vor der Schichtabscheidung auf das Substrat aufgelegt werden. Die Schablonentechnik setzt voraus, dass die Substrate eben sind, damit das abzuscheidende Material die Schablone nicht unterwandert. Zu den additiven Verfahren gehört auch die MID-Technik (moulded interconnect devices; spritzgegossene Schaltungsträger).

Zu den substraktiven Verfahren gehört die Fotolithografie als Ätzverfahren oder als Lift-Off-Verfahren. Beim Ätzverfahren wird eine Lackmaske auf die zu strukturierende Schicht aufgebracht, um diese danach lokal zu ätzen. Beim Lift-Off-Verfahren wird vor der Schichtabscheidung eine Lackmaske auf das Substrat als Opferschicht aufgebracht. Um die Lackmaske ablösen und die darüber liegende Schicht abheben zu können, dürfen bei der Schichtabscheidung die seitlichen Kanten der Lackmaske nicht bedeckt werden.

Aus der EP 0 193 820 ist ein Lift-Off-Verfahren bekannt, bei dem temperaturbeständige Abdeckmassen, welche sich in organischen Lösemitteln oder Wasser lösen lassen, mittels Siebdruck, Dispensen mit Dosiernadeln oder Tintenstrahldruck aufgebracht werden. Nach Abscheidung der Funktionsschicht werden die Opferschichten in organischen Lösungsmitteln oder Wasser aufgelöst.

Die DE 10 2008 036 853 beschreibt ein Lift-Off-Verfahren, bei dem eine wasserlösliche Ablösemasse mittels eines Tintenstrahldruckers auf ein Substrat aufgebracht wird. Die wasserlösliche Ablösemasse besteht aus einem wasserlöslichen Bindemittel, etwa einem wasserlöslichen Harz.

Nachteilig sind die bekannten Verfahren zur Herstellung einer strukturierten Dünnschicht oftmals unproduktiv und teuer sowie auf ebene Substrate beschränkt. Ferner können bei den bekannten Verfahren große Mengen an zu entsorgenden Abfallprodukten anfallen. Zudem sind die bekannten Verfahren häufig verfahrenstechnisch aufwändig.

Eine Aufgabe der Erfindung besteht darin, ein Verfahren zur Herstellung einer strukturierten Dünnschicht bereitzustellen; welches kostengünstig und verfahrenstechnisch einfach ist und welches insbesondere nicht auf die Beschichtung ebener Oberflächen beschränkt ist.

Das erfindungsgemäße Verfahren zur Herstellung einer strukturierten Dünnschicht umfasst: Aufbringen wenigstens einer Opferschichtstruktur auf ein Substrat, Aufbringen einer Funktionsschicht in Dünnschichttechnik auf das Substrat, wobei die Funktionsschicht zumindest bereichsweise das Substrat und zumindest bereichsweise die Opferschichtstruktur bedeckt, und Abtragen der Opferschichtstruktur vom Substrat mittels eines Strahls einer Flüssigkeit, wobei die Opferschichtstruktur zumindest bereichsweise porös ausgebildet ist. Durch das erfindungsgemäße Verfahren lassen sich strukturierte Dünnschichten kostengünstig und verfahrenstechnisch einfach herstellen.

Die zumindest bereichsweise poröse Opferschichtstruktur kann offenporig oder geschlossenporig ausgebildet sein. Die Poren der Opferschichtstruktur können mit einem Gas, insbesondere mit Luft, einer Flüssigkeit oder einem Feststoff zumindest bereichsweise gefüllt sein. Insbesondere können die Poren der Opferschichtstruktur mit einem Material gefüllt sein, welches sich von dem Material der porösen Opferschichtstruktur unterscheidet. Die Porosität der Opferschichtstruktur erleichtert ein Abtragen der Opferschichtstruktur mittels eines Strahls einer Flüssigkeit. Die Porosität der Opferschichtstruktur ermöglicht ein rein mechanisches Abtragen.

Unter einer rein mechanischen Abtragung wird eine Abtragung verstanden, bei welcher das Material der Opferschichtstruktur zumindest im Wesentlichen nicht in der Flüssigkeit aufgelöst wird und die Opferschichtstruktur zumindest im Wesentlichen nur durch den Druck des Flüssigkeitsstrahls vom Substrat entfernt wird. Insbesondere kann die Opferschichtstruktur aus einem Material gebildet sein, welches in der Flüssigkeit zumindest im Wesentlichen nicht lösbar ist. Vorteilhaft können die abgetragenen Bestandteile der Opferschichtstruktur aus der verwendeten Flüssigkeit gefiltert und getrennt entsorgt werden. Eine verfahrenstechnisch aufwändige Entsorgung von Schadstoffen kann so vermieden werden.

In bevorzugten Ausführungsformen kann die Opferschichtstruktur als Paste auf das Substrat aufgebracht werden, wobei die Paste zumindest Feststoffpartikel, insbesondere Glaspartikel und/oder Keramikpartikel, und ein Anpastmittel mit einem Binder, vorzugsweise einem organischen Binder, und einem Lösungsmittel, vorzugsweise einem organischen Lösungsmittel, enthalten kann. Das Anpastmittel kann zum Beispiel ein Siebdrucköl sein. Vorteilhaft kann die Opferschichtstruktur mittels Siebdruck auf das Substrat aufgebracht werden. Auf diese Weise kann die Opferschichtstruktur verfahrenstechnisch einfach mit variabler Geometrie auf das Substrat aufgebracht werden. Alternativ kann die Opferschichtstruktur mittels Dispensen auf das Substrat aufgebracht werden.

Nach dem Aufbringen auf das Substrat kann die Paste getrocknet werden, insbesondere bei 20 °C bis 300 °C, bevorzugt bei 100 °C bis 200 °C, für 1 min bis 500 min, bevorzugt für 5 min bis 30 min, getrocknet werden. Durch das Trocknen der Paste kann eine poröse Opferschichtstruktur auf dem Substrat ausgebildet werden. Durch die Wahl der Partikelgröße oder der Partikelgrößenverteilung der Feststoffpartikel in der Paste kann die Porosität der Opferschichtstruktur gezielt eingestellt werden.

In bevorzugten Ausführungsformen kann die Opferschichtstruktur eine Schichtdicke von 100 nm bis 100 µm, bevorzugt von 1 µm bis 50 µm, besonders bevorzugt von 10 µm bis 40 µm, aufweisen. Die Schichtdicke der Opferschichtstruktur kann insbesondere dicker sein als die Schichtdicke der Funktionsschicht. Durch eine im Vergleich zur Schichtdicke der Funktionsschicht erhöhte Schichtdicke der Opferschichtstruktur kann ein mechanisches Abtragen der Opferschichtstruktur erleichtert werden.

Die Flüssigkeit zum Abtragen der Opferschichtstruktur kann Wasser und/oder organische Lösungsmittel umfassen. Ferner kann die Flüssigkeit Zusatzstoffe enthalten, etwa Additive und/oder Reinigungsmittel. Geeignete Reinigungsmittel hat beispielsweise die Firma Zestron Europe, Ingolstadt, Deutschland, in ihrem Programm.

Der Strahl einer Flüssigkeit kann mit einem Druck von 1 bar bis 50 bar, insbesondere 2 bar bis 10 bar, erzeugt werden und/oder aus einer Düse, insbesondere einer Flachstrahldüse, mit einem Abstrahlwinkel von 1° bis 120°, vorzugsweise 10° bis 45°, in Bezug auf eine zentrale Achse der Düse austreten und/oder eine Strahllänge von weniger als 250 mm, bevorzugt weniger als 100 mm, aufweisen. Auf diese Weise kann die Opferschichtstruktur effizient vom Substrat abgetragen werden. Der Strahl kann kegelförmig oder als Flachstrahl aus der Düse austreten. Selbstverständlich können auch mehrere Düsen zum Abtragen der Opferschichtstruktur verwendet werden.

In bevorzugten Ausführungsformen kann die Funktionsschicht eine dielektrische Schicht, insbesondere eine Antireflexschicht, eine Widerstandsschicht, eine Halbleiterschicht, oder eine elektrisch leitfähige Schicht sein. Die Funktionsschicht kann insbesondere Nickel, Gold, Kupfer und/oder Aluminium umfassen. Die Funktionsschicht kann ein- oder mehrlagig ausgebildet sein. Insbesondere kann die Funktionsschicht eine erste Lage aus einem ersten Material und eine zweite Lage aus einem zweiten Material aufweisen. Die erste Lage kann insbesondere Nickel umfassen und die zweite Lage kann insbesondere Gold umfassen. Insbesondere kann die Funktionsschicht ein Metall und/oder ein Metalloxid umfassen.

Vorteilhaft kann die Funktionsschicht durch chemische Gasphasenabscheidung, insbesondere plasmagestützte Gasphasenabscheidung, und/oder physikalische Gasphasenabscheidung, insbesondere Sputtern oder Aufdampfen, aufgebracht werden. Die Funktionsschicht kann eine Schichtdicke von 10 nm bis 10 µm, bevorzugt von 500 nm bis 5 µm, besonders bevorzugt von 1 µm bis 3 µm, aufweisen.

In bevorzugten Ausführungsformen kann das Substrat aus einer Keramik, Silizium und/oder einem Kunststoff, insbesondere einem temperaturbeständigen Kunststoff, gebildet sein. Das zu beschichtende Substrat kann eben sein. Alternativ kann das zu beschichtende Substrat uneben sein, insbesondere eine Geometrie aufweisen, welche von einer ebenen Fläche abweicht. Die Opferschichtstruktur und/oder die Funktionsschicht können auf einer Fläche des Substrats mit Flächennormalen in unterschiedlicher Richtung aufgebracht werden. Vorteilhaft ist das Verfahren zur Herstellung einer strukturierten Dünnschicht nicht auf die Beschichtung ebener Oberflächen beschränkt.

Ein offenbartes Bauteil oder ein offenbarter Schaltungsträger umfasst ein Substrat und eine mittels des erfindungsgemäßen Verfahrens auf dem Substrat aufgebrachte strukturierte Dünnschicht, die von der Funktionsschicht gebildet oder aus der Funktionsschicht durch weitere Behandlung erhalten wird. Das Bauteil kann insbesondere ein elektronisches Bauelement sein. Bevorzugt kann das Bauteil ein oberflächenmontiertes Bauelement (SMD) sein oder als Teil eines oberflächenmontierten Bauelements ausgebildet sein. Insbesondere kann das Bauteil ein Bauelement einer Solarzelle sein.

Die strukturierte Dünnschicht kann auf einer Fläche des Bauteils mit Flächennormalen in unterschiedlicher Richtung aufgebracht sein. Somit ist die Anordnung der strukturierten Dünnschicht nicht auf ebene Flächen des Bauteils beschränkt.

Die Erfindung wird nachfolgend anhand von Figuren beispielhaft näher erläutert. An den Figuren und Beschreibung offenbar werdende Merkmale bilden je einzeln und in jeder Merkmalskombination die Gegenstände der Ansprüche vorteilhaft weiter. Es zeigen:
- Fig. 1: in einer Prinzipdarstellung ein Verfahren zur Herstellung einer strukturierten Dünnschicht, und
- Fig. 2: ein Bauteil mit einer strukturierten Dünnschicht in einem Querschnitt.

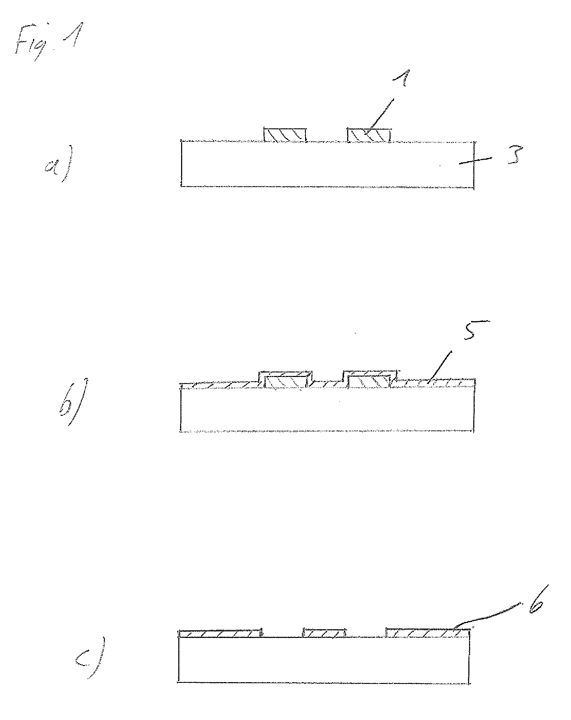

In der Fig. 1 ist schematisch ein Verfahren zur Herstellung einer strukturierten Dünnschicht 6 dargestellt. Zunächst wird eine pöröse Opferschichtstruktur 1 in einem Verfahrensschritt a) auf ein Substrat 3 aufgebracht. Die Opferschichtstruktur 1 kann als Paste auf das Substrat 3 insbesondere mittels Siebdruck aufgebracht werden. Bevorzugt umfasst die Paste dabei Feststoffpartikel, und ein Anpastmittel mit einem Binder, vorzugsweise einem organischen Binder, und einem Lösungsmittel, vorzugsweise einem organischen Lösungsmittel. Insbesondere kann das Anpastmittel ein Siebdrucköl sein. Nach dem Aufbringen der Paste auf das Substrat 3 kann die Paste insbesondere bei 150 °C für 10 Minuten getrocknet werden und so die poröse Opferschichtstruktur 1 gebildet werden.

In einem Verfahrensschritt b) wird eine Funktionsschicht 5 in Dünnschichttechnik, insbesondere durch chemische oder physikalische Gasphasenabscheidung, auf das Substrat 3 aufgebracht. Gemäß einem Ausführungsbeispiel bedeckt die Funktionsschicht 5 sowohl das Substrat 3 als auch die Opferschichtstruktur 1. Bevorzugt kann die Funktionsschicht 5 eine erste Lage, insbesondere aus Nickel, und eine zweite Lage, insbesondere aus Gold, aufweisen.

Nach dem Aufbringen der Funktionsschicht 5 wird in einem Verfahrensschritt c) die Opferschichtstruktur 1 vom Substrat 3 mittels eines Strahls einer Flüssigkeit abgetragen. Die Abtragung der Opferschichtstruktur 1 kann zumindest im Wesentlichen rein mechanisch erfolgen. Durch das Abtragen der Opferschichtstruktur 1 vom Substrat 3 wird die strukturierte Dünnschicht 6 von der Funktionsschicht 5 gebildet.

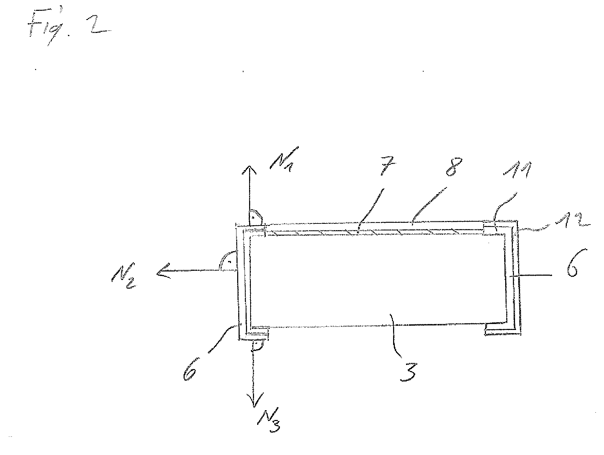

Die Fig. 2 zeigt ein Bauteil mit einem Substrat 3 und einer mittels des erfindungsgemäßen Verfahrens aufgebrachten strukturierten Dünnschicht 6. Wie aus der Fig. 2 hervorgeht, ist die Dünnschicht 6 auf einer Fläche des Bauteils mit Flächennormalen N₁, N₂ und N₃ in unterschiedlicher Richtung aufgebracht. Die strukturierte Dünnschicht 6 weist eine erste Lage 11, insbesondere aus Nickel, und eine zweite Lage 12, insbesondere aus Gold, auf.

An der Oberseite des Substrats 3 ist in einem Bereich, welcher nicht von der strukturierten Dünnschicht 6 bedeckt ist, eine temperaturabhängige Widerstandsschicht 7 vorgesehen. Bevorzugt kann die temperaturabhängige Widerstandsschicht 7 aus Platin bestehen. Auf der Widerstandsschicht 7 ist eine Deckschicht 8 aus Glas aufgebracht.

Die strukturierte Dünnschicht 6 wurde durch das in der Figur 1 gezeigte Verfahren hergestellt. An den Bereichen des Substrats 3, welche nicht von der strukturierten Dünnschicht 6 bedeckt sind, war die poröse Opferschichtstruktur 1 vorgesehen, welche mittels eines Strahls einer Flüssigkeit vom Substrat 3 abgetragen wurde. Die strukturierte Dünnschicht 6 ist auf diese Weise von der Funktionsschicht 5 gebildet.

## Patentansprüche

1. Verfahren zur Herstellung einer strukturierten Dünnschicht (6), umfassend:
a) Aufbringen wenigstens einer Opferschichtstruktur (1) auf ein Substrat (3),
b) Aufbringen einer Funktionsschicht (5) in Dünnschichttechnik auf das Substrat (3), wobei die Funktionsschicht (5) zumindest bereichsweise das Substrat (3) und zumindest bereichsweise die Opferschichtstruktur (1) bedeckt,
c) Abtragen der Opferschichtstruktur (1) vom Substrat (3) mittels eines Strahls einer Flüssigkeit,
d) wobei die Opferschichtstruktur (1) zumindest bereichsweise porös ausgebildet ist und rein mechanisch mittels des Strahls der Flüssigkeit abgetragen wird.

2. Verfahren nach Anspruch 1, **dadurch gekennzeichnet, dass** die Opferschichtstruktur (1) als Paste auf das Substrat (3) aufgebracht wird, wobei die Paste zumindest Feststoffpartikel, insbesondere Glaspartikel und/oder Keramikpartikel, und ein Anpastmittel mit einem Binder, vorzugsweise einem organischen Binder, und einem Lösungsmittel, vorzugsweise einem organischen Lösungsmittel, enthält.

3. Verfahren nach Anspruch 2, **dadurch gekennzeichnet, dass** die Paste nach dem Aufbringen auf das Substrat (3) getrocknet wird, insbesondere bei 20 °C bis 300 °C, bevorzugt bei 100 °C bis 200 °C, für 1 min bis 500 min, bevorzugt für 5 min bis 30 min, getrocknet wird.

4. Verfahren nach einem der vorhergehenden Ansprüche, **dadurch gekennzeichnet, dass** die Opferschichtstruktur (1) eine Schichtdicke von 100 nm bis 100 µm, bevorzugt von 1 µm bis 50 µm, besonders bevorzugt von 10 µm bis 40 µm, aufweist.

5. Verfahren nach einem der vorhergehenden Ansprüche, **dadurch gekennzeichnet, dass** die Flüssigkeit Wasser und/oder organische Lösungsmittel umfasst.

6. Verfahren nach einem der vorhergehenden Ansprüche, **dadurch gekennzeichnet, dass** die Opferschichtstruktur (1) aus einem Material gebildet ist, welches in der Flüssigkeit zumindest im Wesentlichen nicht lösbar ist.

7. Verfahren nach einem der vorhergehenden Ansprüche, **dadurch gekennzeichnet, dass** der Strahl einer Flüssigkeit mit einem Druck von 1 bar bis 50 bar, insbesondere 2 bar bis 10 bar, erzeugt wird und/oder aus einer Düse, insbesondere einer Flachstrahldüse, mit einem Abstrahlwinkel von 1° bis 120°, vorzugsweise 10° bis 45°, in Bezug auf eine zentrale Achse der Düse austritt und/oder eine Strahllänge von weniger als 250 mm, bevorzugt weniger als 100 mm, aufweist.

8. Verfahren nach einem der vorhergehenden Ansprüche, **dadurch gekennzeichnet, dass** die Funktionsschicht (5) eine dielektrische Schicht, insbesondere eine Antireflexschicht, eine Widerstandsschicht, eine Halbleiterschicht, oder eine elektrisch leitfähige Schicht ist.

9. Verfahren nach einem der vorhergehenden Ansprüche, **dadurch gekennzeichnet, dass** die Funktionsschicht (5) durch chemische Gasphasenabscheidung, insbesondere Plasmagestützte Gasphasenabscheidung, und/oder physikalische Gasphasenabscheidung, insbesondere Sputtern oder Aufdampfen, aufgebracht wird.

10. Verfahren nach einem der vorhergehenden Ansprüche, **dadurch gekennzeichnet, dass** die Funktionsschicht (5) eine Schichtdicke von 10 nm bis 10 µm, bevorzugt von 500 nm bis 5 µm, besonders bevorzugt von 1 µm bis 3 µm, aufweist.

11. Verfahren nach einem der vorhergehenden Ansprüche, **dadurch gekennzeichnet, dass** das Substrat (1) aus einer Keramik, Silizium und/oder einem Kunststoff, insbesondere einem temperaturbeständigen Kunststoff, gebildet ist.

12. Verfahren nach einem der vorhergehenden Ansprüche, **dadurch gekennzeichnet, dass** die die Opferschichtstruktur (1) und/oder die Funktionsschicht (5) auf einer Fläche des Substrats (1) mit Flächennormalen in unterschiedlicher Richtung aufgebracht wird.

## Claims

1. A method for manufacturing a structured thin film (6), involving:
a) applying at least one sacrificial layer structure (1) to a substrate (3);
b) applying a functional layer (5) to the substrate (3) using a thin film technique, wherein the functional layer (5) covers at least some regions of the substrate (3) and covers at least some regions of the sacrificial layer structure (1); and
c) removing the sacrificial layer structure (1) from the substrate (3) by means of a jet of liquid,
d) wherein the sacrificial layer structure (1) is formed to be porous in at least some regions and is removed in a purely mechanical way by means of the jet of liquid.

2. The method according to Claim 1, **characterised in that** the sacrificial layer structure (1) is applied to the substrate (3) as a paste, wherein the paste contains at least solid particles, in particular glass particles and/or ceramic particles, and a pasting agent comprising a binder, preferably an organic binder, and a solvent, preferably an organic solvent.

3. The method according to Claim 2, **characterised in that** once it has been applied to the substrate (3), the paste is dried, in particular at 20 °C to 300 °C, preferably at 100 °C to 200 °C, for 1 to 500 minutes, preferably 5 to 30 minutes.

4. The method according to any one of the preceding claims, **characterised in that** the sacrificial layer structure (1) exhibits a layer thickness of 100 nm to 100 µm, preferably 1 µm to 50 µm, particularly preferably 10 µm to 40 µm.

5. The method according to any one of the preceding claims, **characterised in that** the liquid comprises water and/or organic solvents.

6. The method according to any one of the preceding claims, **characterised in that** the sacrificial layer structure (1) is formed from a material which is at least substantially not soluble in the liquid.

7. The method according to any one of the preceding claims, **characterised in that** the jet of liquid is produced at a pressure of 1 to 50 bars, in particular 2 to 10 bars, and/or is emitted from a nozzle, in particular a fan nozzle, at an emission angle of 1° to 120°, preferably 10° to 45°, in relation to a central axis of the nozzle and/or exhibits a jet length of less than 250 mm, preferably less than 100 mm.

8. The method according to any one of the preceding claims, **characterised in that** the functional layer (5) is a dielectric layer, in particular an anti-reflective layer, a resistance layer, a semiconductor layer or an electrically conductive layer.

9. The method according to any one of the preceding claims, **characterised in that** the functional layer (5) is applied using chemical vapour deposition, in particular plasmaenhanced vapour deposition, and/or physical vapour deposition, in particular sputtering or evaporation.

10. The method according to any one of the preceding claims, **characterised in that** the functional layer (5) exhibits a layer thickness of 10 nm to 10 µm, preferably 500 nm to 5 µm, particularly preferably 1 µm to 3 m.

11. The method according to any one of the preceding claims, **characterised in that** the substrate (3) is formed from a ceramic, silicon and/or a plastic, in particular a temperature-resistant plastic.

12. The method according to any one of the preceding claims, **characterised in that** the sacrificial layer structure (1) and/or the functional layer (5) is applied to a surface of the substrate (3) exhibiting surface normals in different directions.

## Revendications

1. Procédé de fabrication d'une couche mince structurée (6), comprenant les étapes suivantes:
a) déposer au moins une structure de couche sacrificielle (1) sur un substrat (3),
b) déposer une couche fonctionnelle (5) par la technique des couches minces sur le substrat (3), dans lequel la couche fonctionnelle (5) recouvre au moins localement le substrat (3) et au moins localement la structure de couche sacrificielle (1), et
c) enlever la structure de couche sacrificielle (1) du substrat (3) au moyen d'un jet d'un liquide,
d) dans lequel la structure de couche sacrificielle (1) est au moins localement poreuse et est enlevée de façon purement mécanique au moyen du jet du liquide.

2. Procédé selon la revendication 1, **caractérisé en ce que** la structure de couche sacrificielle (1) est déposée sous forme de pâte sur le substrat (3), dans lequel la pâte contient au moins des particules de matière solide, en particulier des particules de verre et/ou des particules céramiques, et un agent pâteux avec un liant, de préférence un liant organique, et un solvant, de préférence un solvant organique.

3. Procédé selon la revendication 2, **caractérisé en ce que** la pâte est séchée après le dépôt sur le substrat (3), en particulier à 20°C à 300°C, de préférence à 100°C à 200°C, pendant 1 min à 500 min, de préférence pendant 5 min à 30 min.

4. Procédé selon l'une quelconque des revendications précédentes, **caractérisé en ce que** la structure de couche sacrificielle (1) présente une épaisseur de couche de 100 nm à 100 µm, de préférence de 1 µm à 50 µm, et de préférence encore de 10 µm à 40 µm.

5. Procédé selon l'une quelconque des revendications précédentes, **caractérisé en ce que** le liquide comprend de l'eau et/ou des solvants organiques.

6. Procédé selon l'une quelconque des revendications précédentes, **caractérisé en ce que** la structure de couche sacrificielle (1) est formée en une matière, qui est au moins essentiellement insoluble dans le liquide.

7. Procédé selon l'une quelconque des revendications précédentes, **caractérisé en ce que** le jet d'un liquide est produit avec une pression de 1 bar à 50 bar, en particulier de 2 bar à 10 bar, et/ou sort d'une buse, en particulier une buse à jet plat, sous un angle de projection de 1° à 120°, de préférence de 10° à 45°, par rapport à un axe central de la buse et/ou présente une longueur de jet de moins de 250 mm, de préférence de moins de 100 mm.

8. Procédé selon l'une quelconque des revendications précédentes, **caractérisé en ce que** la couche fonctionnelle (5) est une couche diélectrique, en particulier une couche antireflet, une couche de résistance, une couche semi-conductrice, ou une couche électriquement conductrice.

9. Procédé selon l'une quelconque des revendications précédentes, **caractérisé en ce que** la couche fonctionnelle (5) est déposée par dépôt chimique en phase gazeuse, en particulier par dépôt en phase gazeuse assisté au plasma, et/ou par dépôt physique en phase gazeuse, en particulier par pulvérisation cathodique ou dépôt de vapeur.

10. Procédé selon l'une quelconque des revendications précédentes, **caractérisé en ce que** la couche fonctionnelle (5) présente une épaisseur de couche de 10 nm à 10 µm, de préférence de 500 nm à 5 µm, de préférence encore de 1 µm à 3 µm.

11. Procédé selon l'une quelconque des revendications précédentes, **caractérisé en ce que** le substrat (3) est formé en une céramique, en silicium et/ou en une matière synthétique, en particulier en une matière synthétique résistant à la température.

12. Procédé selon l'une quelconque des revendications précédentes, **caractérisé en ce que** la structure de couche sacrificielle (1) et/ou la couche fonctionnelle (5) est déposée sur une surface du substrat (3) avec des normales à la surface de direction différente.
